# EUROPÄISCHE PATENTANMELDUNG

(11) **EP 0 966 171 A2**
(43) Veröffentlichungstag der Anmeldung: **22.12.1999**
(21) Anmeldenummer: 99111813.4
(22) Anmeldetag: 18.06.1999
(51) Int. Cl.: H04Q 7/34

(54) **Verfahren zum Betreiben einer Funkmesseinrichtung und Vorrichtung dafür**

(30) Priorität: 19.06.1998 DE 19827486; 10.08.1998 DE 19836162
(71) Anmelder: WAVETEK GMBH, 85737 Ismaning (DE)
(72) Erfinder: Klenner, Günther, 83022 Rosenheim (DE)
(74) Vertreter: Neumeister, Kurt Gustav

(57) **Zusammenfassung**

Ein Meßverfahren dient zum Betreiben eines Funkmeßplatzes für Qualitätsmessungen an Mobilfunkgeräten, insbesondere Mobiltelefonen, die zum Betrieb an einem Frequenzkanäle aufweisenden Netz vorgesehenen sind, wobei für das zu testende Mobilfunkgerät charakteristische Meßwerte auf zumindest zwei Frequenzen oder Frequenzkanälen ermittelt werden. Charakteristisch für das erfindungsgemäße Meßverfahren ist, daß zu Beginn der Messungen die Art und Anzahl der abzutastenden Frequenzen oder Frequenzkanälen definiert wird und die Meßwerte in den Frequenzkanälen ohne Protokollaustausch zwischen Funkmeßplatz und Mobilgerät abgetastet werden. Ferner betrifft die Erfindung eine Funkmeßeinrichtung. Schließlich verwendet die Erfindung ein Frequenzsprungverfahren zum Testen von Funkeinrichtungen.

## Beschreibung

Die vorliegende Erfindung betrifft ein Verfahren zum Betreiben einer Funkmeßeinrichtung für Messungen an zum Betrieb an wenigstens einem, Frequenzkanäle aufweisenden Netz vorgesehenen Funkeinrichtungen, insbesondere Mobiltelefone, wobei für die zu testende Funkeinrichtung charakteristische Meßwerte auf zumindest zwei Frequenzen oder Frequenzkanälen ermittelt werden, und wobei die Meßwerte den Frequenzkanälen zugeordnet sind. Gemäß einem zweiten Aspekt betrifft die vorliegende Erfindung ein Verfahren zum Einstellen oder Abgleichen von wenigstens einer zum Betrieb an wenigstens einem, Frequenzkanäle aufweisenden Netz vorgesehenen Funkeinrichtung, insbesondere einem Mobiltelefon, mit einer Funkmeßeinrichtung, wobei für die zu testende Funkeinrichtung charakteristische Meßwerte auf zumindest zwei Frequenzen oder Frequenzkanälen ermittelt werden, und wobei die Funkeinrichtung für ein Frequenzsprungverfahren geeignet ist.

Ein derartiges Meßverfahren ist bereits bekannt. Dazu werden auf einzelnen Frequenzkanälen eines zellularen Netzes jeweils Meßwerte zur Bestimmung der Übertragungsqualität gemessen. Die Auswahl von mehreren Frequenzkanälen dient dazu zu überprüfen, ob das Mobilfunkgerät über den gesamten Frequenzbereich seine Spezifikationen erfüllt. Die Erfassung der relevanten physikalischen Meßwerte zur Charakterisierung der Kanaleigenschaften ein wichtiges Hilfsmittel bzw. Werkzeug zur Bestimmung der HF-Parameter und damit zur Qualitätssicherung bei der Fertigung und Wartung von Mobiltelefonen dar. Dazu werden die Frequenzkanäle des verwendeten Frequenzbandes sequentiell durchgeschaltet, wobei eine komplette Vermessung des jeweiligen Frequenzkanals nach den Meßwerten wie Leistung, Frequenz, Phase, "Burst"-Verhalten, Zeitverhalten und Bitfehlerrate durchgeführt wird, bevor zum nächsten Kanal weitergeschaltet wird. Um das zu testende Mobilfunkgerät auf den jeweils nächsten Frequenzkanal weiterzuschalten und einzustellen, müssen dabei intermittierend zeit- und programmieraufwendige Protokollsequenzen mit Kommandosignalen zwischen dem zu testenden Mobilfunkgerät und dem Funkmeßplatz ausgetauscht werden.

Ferner ist es bekannt bei der Reparatur und Wartung von Mobilfunkgeräten, Einstellungen und Abgleiche an diesen vorzunehmen, wobei die Auswirkungen derartiger Einstellungen und Abgleiche auf alle Bereiche eines oder mehrerer Frequenzbänder nur sehr zeitaufwendig festzustellen sind, weshalb ein derartiger Abgleich zeitaufwendig, kostenintensiv und schwer zu optimieren ist.

Schließlich sind in Stand der Technik Mobilfunknetze bekannt, die ein sogenanntes Frequenzsprungverfahren aufweisen. Ein Beispiel hierfür sind sogenannte GSM-Netze. Dabei wird, während des Übertragungsbetriebs eines Mobiltelefons das digitalisierte Sprachsignal mittels eines Frequenzsprungverfahrens ("frequency hopping") auf mehreren Frequenzkanälen eines Hochfrequenz-(HF)-Bands übertragen, wobei in Sekundenbruchteilen von einem Frequenzkanal zum nächsten geschaltet wird.

Unbefriedigend bei diesem Stand der Technik ist jedoch, daß die bekannten Meßverfahren zeitaufwendig und somit kostenintensiv ist.

Der vorliegenden Erfindung liegt daher die Aufgabe zugrunde, ein Meßverfahren der eingangs genannten Art zu schaffen, das bei hoher Qualität zeitsparend durchführbar ist.

Die erfindungsgemäße Aufgabe wird in verfahrenstechnischer Hinsicht dadurch gelöst, daß die gesamte Information betreffend die (Ablauf-)Steuerung der Messung zu Beginn der Messungen definiert und von der Funkmeßeinrichtung an die Funkeinrichtung übertragen wird. Gemäß dem zweiten Aspekt der vorliegenden Erfindung wird die erfindungsgemäße Aufgabe dadurch gelöst, daß eine on-line Darstellung der Meßwerte dadurch erfolgt, daß die Steuerung der Messung nach einer vordefinierten Test-Frequenzliste gemäß dem Frequenzsprungverfahren durchgeführt wird. Da aufgrund des Frequenzsprungverfahrens eine Vielzahl von Frequenzen in einer Sekunde abgetastet bzw. durchsprungen wird, können Auswirkungen eines Abgleichs oder einer Einstellung an Hard- und Software eines Mobiltelefons für einen großen Frequenzbereich, insbesondere auch für mehrere Frequenzbänder, in Echtzeit bzw. simultan auf einem Bildschirm bzw. Monitor angezeigt, und dadurch schneller und besser durchgeführt werden.

Charakteristisch für die Erfindung ist mithin, daß, anstatt zwischen den Messungen im jeweiligen Frequenzkanal intermittierende Protokollsequenzen zur Weiterschaltung und Einstellung des Mobilgeräts zu bewirken, vor der Durchführung der eigentlichen Messungen eine Protokollphase mit einer Vereinbarungsliste der zu schaltenden Frequenzkanäle stattfindet, wobei die dem Netzwerk inhärente Frequenzsprung-Eigenschaft ausgenutzt wird. Durch den Wegfall intermittierender Protokollsequenzen, die jeweils eine Dauer im Sekundenbereich aufweisen, läßt sich die für das Testen erforderliche Zeit im wesentlichen auf den Meßvorgang beschränken und somit sukzessive beträchtlich Zeit sparen. Dabei kann zu Beginn der Messungen die Reihenfolge der abzutastenden Frequenzkanäle definiert werden. Erfindungsgemäß wird daher die Messung eines charakteristischen Meßwerts bzw. Parameters zwischen zwei, insbesondere unmittelbar aufeinanderfolgenden, Frequenzsprüngen durchgeführt. Vorzugsweise wird vor dem erfindungsgemäßen Meßverfahren eine Messung bzw. ein Test dahingehend durchgeführt, ob das Mobilfunkgerät ordnungsgemäß in der Frequenzsprung-Betriebsart funktioniert.

Vorzugsweise ist die gesamte Information betreffend die Steuerung der Messung in der Funkeinrichtung während der Messung gespeichert. Dazu eignet sich vorzugsweise die ein der Speicherung des Hop-Sets dienender RAM-Speicher.

Eine besonders zeitsparende Variante kann darin bestehen, daß die Frequenzkanäle zyklisch abgetastet werden. Alternativ können die Frequenzkanäle auch pseudozufällig abgetastet werden. Dadurch werden die vordefinierten Frequenzkanäle entsprechend ihrer Reihenfolge ständig von neuem durchlaufen, so daß die abgetasteten Meßwerte auch in Echtzeitdarstellung anzeigbar sind und beispielsweise auch der Einfluß einer "Hardware"-Änderung am zu testenden Mobilfunkgerät unmittelbar untersucht werden kann.

Eine meßtechnisch vorteilhafte Variante kann darin bestehen, daß die Frequenzen während der Messungen in einer einzigen Meßreihe kontinuierlich abgetastet werden.

Eine für standardisierte Meßvorgänge bestimmte Weiterbildung des erfindungsgemäßen Verfahrens kann darin bestehen, daß zu Beginn der Messungen die für die Abtastung der Meßwerte erforderliche Meßzeit vordefiniert wird.

In vorrichtungstechnischer Hinsicht wird die oben angegebene Aufgabe bei einer Vorrichtung bzw. einem Funkmeßplatz mit wenigstens einem Signalgenerator zur Erzeugung von Testsignalen und Meßwertsensoren zum Abtasten von für die zu testende Funkeinrichtung charakteristischen Meßwerten dadurch gelöst, daß für jeden Frequenzkanal jeweils ein Speicherfeld des Funkmeßplatzes zum Abspeichern der abgetasteten Meßwerte vorgesehen ist. Dabei ist ein dem zu testenden Mobilfunkgerät zugewiesener Speicher zumindest teilweise zur Aufnahme von den definierten Frequenzkanälen zugeordneten Daten vorgesehen. Somit ist einerseits die Information über die Liste der abzutastenden Frequenzkanäle für das zu testende Mobilfunkgerät verfügbar, während andererseits die abgetasteten Daten für die insgesamt abgearbeiteten Frequenzkanäle matrixartig in einem Speicherfeld abspeicherbar sind.

Vorteilhafterweise umfassen die charakteristischen Meßwerte die Empfindlichkeit BER (bit error rate). Dieser Meßparameter läßt sich erfindungsgemäß in der Hopping-Betriebsart für mehrere Frequenzen und den einzelnen Frequenzen zugeordnet messen.

Nachstehend soll eine Ausführungsform der Erfindung anhand eines Ausführungsbeispiels näher erläutert werden.

Zur Qualitätssicherung werden Mobiltelefone während der Herstellung und nach der Fertigung bei der Endkontrolle auf Einhaltung der, für den Betrieb am Netz erforderlichen Spezifikationen getestet. Bei der Herstellung dienen derartige Testmessungen dazu, fehlerhafte Komponenten auszutauschen, um Fertigungsfehler zu minimieren und somit die Fertigungsqualität aufrechtzuerhalten, während sie bei der Endkontrolle der Überprüfüng der Basisfunktionen und dem Endabgleich der Mobiltelefone dienen. Zudem lassen sich bei der Fehlersuche in schadhaften Mobiltelefonen mithilfe derartiger Testmessungen in einem Reparaturbetrieb oder bei einem Händler auf ihre Basisfunktionen hin überprüfen. Um derartige Qualitätsmessungen durchzuführen, bedarf es einer Testausrüstung zur Durchführung von Hochfrequenz-(HF)-Tests, eines sogenannten Funkmeßplatzes.

Dabei werden die für die relevanten Grenzwert-Spezifikationen charakteristischen HF-Parameter, wie z.B. Leistung, Frequenz, Phasen-/Frequenzfehler, "Burst"-Verhalten, Zeitverhalten und Bitfehlerrate für einzelne Frequenzkanäle eines Netzes gemessen. Beim Stand der Technik werden diese Qualitätsmessungen für die einzelnen Frequenzkanäle sequentiell durchgeführt, wobei in jedem einzelnen Frequenzkanal der komplette Satz von Meßwerten bzw. HF-Parametern abgetastet wird, bevor auf den jeweils nächsten Frequenzkanal umgeschaltet wird, um das Meßprocedere von neuem zu starten. Das Umschalten zwischen den einzelnen Frequenzkanälen erfordert jeweils den Austausch von Datenpaketen bzw. Telegrammen mit Kommandosignalen zwischen dem Funkmeßplatz und dem zu testenden Mobiltelefon, um das Mobiltelefon auf den jeweils anderen Frequenzkanal, insbesondere auch im Hinblick auf den Zeitpunkt der Umstellung, einzustellen. Aufgrund der zwischen Meßplatz und Mobiltelefon auszutauschenden Kommandosignalen und der somit erforderlichen Synchronisation des Meßplatzes mit dem Mobiltelefon zur Weiterschaltung zwischen den Frequenzkanälen mit dazwischenliegenden Meßzyklen ergeben sich mithin insgesamt lange Meßzeiten, die einerseits durch die reine Meßzeit und andererseits durch die Kommandointervalle bedingt sind.

Hier setzt nun das erfindungsgemäße Verfahren an, indem vor Beginn der eigentlichen Messungen eine Liste von Frequenzkanälen definiert wird, die dann zyklisch durchlaufen werden, wobei auf jedem dieser Frequenzkanäle Meßwerte ermittelt und dem jeweiligen Kanal individuell zugeordnet werden. Die Messungen werden dann derart durchgeführt, daß während eines ersten "Burst", also dem aufgrund des zugrundeliegenden Zeitmultiplexverfahrens dem zum Senden vorgesehenen Zeitschlitzes, eine Messung in einem unteren Frequenzkanal durchgeführt wird, danach das Mobiltelefon in den nächsten definierten Frequenzkanal für die dafür vorgesehene Meßreihe springt, wobei die dabei ermittelten Meßdaten zyklisch fortlaufend einem dafür vorgesehenen Speicherfeld des Funkmeßplatzes zugeordnet werden und somit die Meßergebnisse in Echtzeit anzeigbar sind.

Der erfindungsgemäße Funkmeßplatz überträgt an die das Mobilfunkgerät eine sogenannte hopping-Liste, welche als Hop-Set in einem RAM in dem Mobilfunkgerät gespeichert ist. Um die Spezifikationen des Mobiltelefons über das gesamte Frequenzband zu testen, werden beispielsweise drei Frequenzen, eine untere Frequenz, eine mittlere Frequenz und eine obere Frequenz in dem Band zu Testzwecken ausgewählt. Falls z. B. die Messung bezüglich der Leistung beginnt, so wird dieser Parameter gemessen, bis die erforderlichen Testergebnisse für alle drei Frequenzen erhalten wurden. Da in der zum Testen aktivierten Frequenzsprungbetriebsart das Mobilfunkgerät (und auch die Testeinrichtung) in Bruchteilen von Sekunden (d. h. in einem sogenannten Burst) zwischen den einzelnen Frequenzen springt, kann die gesamte Leistungsmessung nicht innerhalb der Verweildauer bei einer Frequenz durchgeführt werden. Somit wird die Messung während des ersten Bursts lediglich gestartet und bei einem neuerlichen Erreichen derselben Frequenz im Hopping-Zyklus fortgesetzt. Die Ergebnisse der jeweiligen Teilmessungen werden in einem Speicher des Testers abgelegt und können kombiniert werden, um vollständige Testdaten zur Leistungsmessung bzw. auch für darauffolgende Messungen zu erhalten.

Durch den Wegfall der durch die Kommandosignale beim Stand der Technik anfallenden Zeitintervalle, mit denen ein Wechsel des Frequenzkanals signalisiert wird, werden die Meßdaten kontinuierlich aufgenommen und nachfolgend den einzelnen Frequenzkanälen zugeordnet und abgespeichert, so daß sich gegenüber dem Stand der Technik eine erhebliche Beschleunigung des Meßprocederes ergibt. Die beim erfindungsgemäßen Verfahren erforderlichen Kommandosignale werden somit vor dem Starten der Meßdatenabtastung während eines einzigen vorangehenden Kommandosignal-Intervalls ausgetauscht, wobei eine Liste der abzutastenden Frequenzkanäle und gegebenenfalls ihrer Reihenfolge definiert wird.

Gerade im weitverbreiteten und ständig weiter an Bedeutung gewinnenden "GSM"-("global system for mobile communications ")-Mobilfunknetz mit dem D-Netz, einem zellularem Netz bei etwa 900 Megahertz, kann eine Reduktion der Testzeiten aufgrund des Wegfalls der intermittierenden Kommandointervalle von typischerweise bis zu drei Sekunden zu einer insgesamt erheblichen Verkürzung der Testzeit und somit vorteilhaft zu einer Kostensenkung führen. Dabei wird auf die Frequenzsprungeigenschaft des GSM-Netzwerks zurückgegriffen, die darin besteht, daß die Gefahr von Störungen durch die Verwendung mehrere Frequenzkanäle, die in einer bestimmten Reihenfolge von Burst zu Burst umgeschaltet werden, vermindert wird.

Der zur Durchführung des erfindungsgemäßen Verfahrens bestimmte Funkmeßplatz weist einen Signalgenerator, mit dem hochfrequente Testsignale für das zu testende Mobilfunkgerät erzeugbar sind, und Sensoren zum Erfassen charakteristischer Meßwerte auf. Über entsprechende Schnittstellen und hochauflösende Analog-Digital- und Digital-Analog-Wandler sind diese Komponenten mit einer zentralen Computersteuerung elektrisch wirkverbunden. Die gemessenen Daten werden in einen Speicher aufgenommen, wobei die einem bestimmten Frequenzkanal zugehörenden Daten jeweils ein Speicherfeld belegen.

Zusammenfassend sei bemerkt, daß das erfindungsgemäße Meßverfahren auf der "Hopping"-Fähigkeit von Funkstationen beruht, wie sie beispielsweise bei der "GSM"-Technik üblich ist. Die vollständige Vermessung einzelner Frequenzkanäle wird dann im "Hopping"-Modus durchgeführt. Da sich die Kommandosignale nur wenig von der üblichen Anfängssignalisierung unterscheidet, verzögert sich der Beginn des Funktionstests nur unwesentlich. Der Vorteil liegt im Wegfall der Umschaltkommandozeiten (Signalisierung und Zeitsteuerung bzw. Timing des Frequenzwechsels). Da die zu vermessende Funkstation eigenständig durch die Meßfrequenzen springt, können die Meßdaten kontinuierlich aufgenommen und danach den entsprechenden Frequenzen zugeordnet werden.

In vorteilhafter Weise lassen sich in Echtzeitdarstellung Auswirkungen von Änderungen an der Hard- und/oder Software des zu testenden Mobilfunkgeräts, wie zum Beispiel der Einfluß eines instantan vorgenommenen Abgleichs (Einstellen eines Trimmers oder eines Arbeitspunktes eines Transistors, Verbiegen einer Luftspule...), nahezu gleichzeitig (on-line) auf mehreren Frequenzkanälen anzeigen. Zudem läßt sich beispielsweise die Empfindlichkeit über mehrere Frequenzkanäle in Echtzeit bestimmen.

Die Erfindung wurde zuvor anhand von bevorzugten Ausführungsbeispielen beschrieben. Für einen Fachmann ist es jedoch offensichtlich, daß verschiedene Abwandlungen und Modifikationen gemacht werden können, ohne von dem der Erfindung zugrundeliegenden Gedanken abzuweichen. Insbesondere umfaßt die Erfindung die Verwendung der Hopping-Fähigkeit einer Funkeinrichtung, um einen einzelnen Frequenzkanälen zugeordneten Funktionstest zu beschleunigen.

## Patentansprüche

1. Verfahren zum Betreiben einer Funkmeßeinrichtung für Messungen an zum Betrieb an wenigstens einem, Frequenzkanäle aufweisenden Netz vorgesehenen Funkeinrichtungen, insbesondere Mobiltelefonen, wobei für die zu testende Funkeinrichtung charakteristische Meßwerte auf zumindest zwei Frequenzen oder Frequenzkanälen ermittelt werden, und wobei die Meßwerte den Frequenzkanälen zugeordnet sind, dadurch gekennzeichnet, daß die Information betreffend die Steuerung der Messung zu Beginn der Messungen definiert und von der Funkmeßeinrichtung an die Funkeinrichtung übertragen wird.

2. Verfähren nach Anspruch 1, dadurch gekennzeichnet, daß die Meßwerte in den jeweiligen Frequenzkanälen ohne, insbesondere mehrmaligen und intermittierenden, Protokollaustausch zwischen Funkmeßeinrichtung und Funkeinrichtung abgetastet werden.

3. Verfahren nach Anspruch 1 oder 2, dadurch gekennzeichnet, daß die gesamte Information betreffend die Steuerung der Messung in der Funkeinrichtung während der Messung gespeichert ist.

4. Verfahren nach einem der Ansprüche 1 bis 3, dadurch gekennzeichnet, daß die Information die Anzahl, die Art, die Testzeiten und die Reihenfolge der abzutastenden Frequenzen oder Frequenzkanäle, sowie den Signalpegel für die Messungen, aufweist.

5. Verfahren nach einem der Ansprüche 1 bis 4, dadurch gekennzeichnet, daß die Funkeinrichtung für ein Frequenzsprungverfahren geeignet ist. und daß die Steuerung der Messung nach einer vordefinierten Test-Frequenzliste gemäß dem Frequenzsprungverfahren durchgeführt wird.

6. Verfahren nach einem der Ansprüche 1 bis 5, dadurch gekennzeichnet. daß die definierten Frequenzkanäle zyklisch abgetastet werden.

7. Verfahren nach einem der Ansprüche 1 bis 6, dadurch gekennzeichnet, daß die definierten Frequenzkanäle während der Messungen in einer einzigen Meßreihe kontinuierlich abgetastet werden.

8. Verfahren nach einem der Ansprüche 1 bis 7, dadurch gekennzeichnet, daß zu Beginn der Messungen die für die Abtastung der Meßwerte erforderliche Meßzeit vordefiniert wird.

9. Verfahren nach einem der vorhergehenden Ansprüche, dadurch gekennzeichnet, daß die charakteristischen Meßwerte die Empfindlichkeit BER aufweist.

10. Verfahren zum Einstellen oder Abgleichen von wenigstens einer zum Betrieb an wenigstens einem, Frequenzkanäle aufweisenden Netz vorgesehenen Funkeinrichtung, insbesondere einem Mobiltelefon, mit einer Funkmeßeinrichtung, wobei für die zu testende Funkeinrichtung charakteristische Meßwerte auf zumindest zwei Frequenzen oder Frequenzkanälen ermittelt werden, und wobei die Funkeinrichtung für ein Frequenzsprungverfahren geeignet ist, dadurch gekennzeichnet, daß eine on-line Darstellung der Meßwerte dadurch erfolgt, daß die Steuerung der Messung nach einer vordefinierten Test-Frequenzliste gemäß dem Frequenzsprungverfahren durchgeführt wird.

11. Verfahren nach Anspruch 10, dadurch gekennzeichnet, daß die Darstellung von mehreren unterschiedlichen Frequenzen zugeordneten Meßwerten gleichzeitig auf einem Monitor erfolgt.

12. Funkmeßeinrichtung, insbesondere zur Durchführung des Verfahrens nach einem der vorhergehenden Ansprüche, dadurch gekennzeichnet, daß eine on-line Darstellung der Meßwerte dadurch erfolgt, daß die Steuerung der Messung nach einer vordefinierten Test-Frequenzliste gemäß dem Frequenzsprungverfahren durchgeführt wird.

13. Funkmeßeinrichtung, insbesondere zur Durchführung des Verfahrens nach einem der vorhergehenden Ansprüche, dadurch gekennzeichnet, daß die Information betreffend die Steuerung der Messung zu Beginn der Messungen definiert und von der Funkmeßeinrichtung an die Funkeinrichtung übertragen wird.

14. Funkmeßeinrichtung nach Anspruch 12 oder 13, gekennzeichnet durch wenigstens einem Signalgenerator zur Erzeugung von Testsignalen und Meßwertsensoren zum Abtasten von für die zu testende Funkeinrichtung charakteristischen Meßwerten, wobei für jeden Frequenzkanal jeweils ein diesem zugeordnetes Speicherfeld der Funkmeßeinrichung zum Abspeichern der abgetasteten Meßwerte vorgesehen ist.

15. Verwendung einer Frequenzsprungbetriebsart zum Testen von Funkeinrichtungen, zur Abtastung von wenigstens einem Frequenzkanal oder Frequenz, um auf diesem zumindest einen charakteristischen Meßwert zu erhalten.
